# EUROPEAN PATENT APPLICATION

(11) **EP 4 600 995 A1**
(43) Date of publication of application: **13.08.2025**
(21) Application number: 23874707.5
(22) Date of filing: 26.09.2023
(51) Int. Cl.: H01L 21/66, G01N 21/956

(54) **SUBSTRATE PROCESSING SYSTEM AND SUBSTRATE ABNORMALITY DETECTION METHOD**

(30) Priority: 07.10.2022 JP 2022162430
(71) Applicant: Tokyo Electron Limited, Tokyo 107-6325 (JP)
(72) Inventor: NAGAI, Ryu, Kurokawa-gun, Miyagi 981-3629 (JP); ISHIKAWA, Shinya, Kurokawa-gun, Miyagi 981-3629 (JP); SATO, Kenta, Kurokawa-gun, Miyagi 981-3629 (JP); TANAKA, Koki, Kurokawa-gun, Miyagi 981-3629 (JP)
(74) Representative: Hoffmann Eitle
(86) International application number: PCT/JP2023/034814
(87) International publication number: WO 2024/075579

(57) **Abstract**

This substrate processing system includes a load port, a processing chamber, a measurer, and a controller. The load port is configured such that a storage container containing a substrate can be connected thereto. The processing chamber is configured to implement substrate processing on the substrate. The measurer is provided on a path for transporting the substrate between the storage container and the processing chamber, and is configured to measure an in-plane spectral distribution of the substrate. The controller is configured to create an outlier detection model on the basis of the in-plane spectral distribution of the substrate measured by the measurer, use the created outlier detection model to calculate an in-plane score of the substrate from the measured in-plane spectral distribution of the substrate, and detect abnormality in the substrate on the basis of the calculated score.

## Description

### TECHNICAL FIELD

The present disclosure relates to a substrate processing system and a substrate abnormality detection method.

### BACKGROUND

Patent Document 1 below discloses a substrate processing method for a substrate processing apparatus including a processing chamber that executes processing on a substrate based on a predetermined processing parameter and a measurement chamber that measures a surface profile of the substrate before and after processing, the method including a preprocessing measurement step of measuring the surface profile of the substrate before the processing in the measurement chamber, a first calculation step, performed before initiating transfer of the substrate toward the processing chamber, of calculating a value of the processing parameter required to achieve a target surface profile based on a measured value of the surface profile before the processing, a determination step of determining whether the calculated value of the processing parameter is within a preset allowable range, a second calculation step, performed when the determination step determines that the value is within the allowable range, of recalculating the value of the processing parameter required to achieve the target surface profile based on an adjustment value derived from a measured value of the surface profile after the processing, obtained from the substrate processed most recently in the processing chamber, and based on the measured value of the surface profile before the processing during a period after initiating the transfer of the substrate toward the processing chamber until loading the substrate into the processing chamber, and a processing step of executing processing based on the value of the processing parameter calculated in the second calculation step after loading the substrate into the processing chamber.

### [Prior Art Document]

### [Patent Document]

Patent Document 1: Japanese Laid-Open Publication No. 2008-091816

### SUMMARY

The present disclosure provides a technique to detect an abnormality in a substrate even when a measured value of the surface profile of the substrate is unavailable.

A substrate processing system according to one embodiment of the present disclosure includes a load port, a processing chamber, a measurer, and a controller. The load port is configured to be connectable to a storage container that accommodates a substrate. The processing chamber is configured to perform substrate processing on the substrate. The measurer is provided on a transfer path of the substrate between the storage container and the processing chamber and is configured to measure an in-plane spectral distribution of the substrate. The controller is configured to create an outlier detection model based on the in-plane spectral distribution of the substrate measured by the measurer, to calculate an in-plane score of the substrate from the measured in-plane spectral distribution of the substrate by using the created outlier detection model, and to detect an abnormality in the substrate based on the calculated score.

According to the present disclosure, it is possible to detect an abnormality in a substrate even when a measured value of the surface profile of the substrate is unavailable.

### BRIEF DESCRIPTION OF DRAWINGS

FIG. 1 is a schematic configuration diagram illustrating an example of a configuration of a substrate processing system according to an embodiment.
FIG. 2 is a diagram illustrating a configuration for measuring an in-plane spectral distribution of a substrate according to an embodiment.
FIG. 3 is a diagram illustrating an example of an operation during substrate processing by the substrate processing system according to an embodiment.
FIG. 4A is a diagram illustrating an example of a configuration of a substrate used as a test specimen according to an embodiment.
FIG. 4B is a diagram illustrating an example of the configuration of the substrate used as the test specimen according to the embodiment.
FIG. 5 is a diagram illustrating an example of disposition of measurement points on the substrate according to an embodiment.
FIG. 6 is a diagram illustrating an example of a spectrum for each measurement point on the substrate according to an embodiment.
FIG. 7 is a diagram illustrating an example of center measurement points and periphery measurement points on the substrate according to an embodiment.
FIG. 8A is a diagram illustrating an example of spectra for the center measurement points on the substrate according to an embodiment.
FIG. 8B is a diagram illustrating an example of spectra for the center measurement point and the periphery measurement point on the substrate according to an embodiment.
FIG. 9 is a diagram illustrating an example of an in-plane score distribution of the substrate according to an embodiment.
FIG. 10 is a diagram illustrating an example of a profile of the substrate according to an embodiment.
FIG. 11 is a diagram illustrating an example of an anomaly score for each substrate according to an embodiment.
FIG. 12 is a flowchart illustrating an example of a substrate processing flow including processing of a substrate abnormality detection method according to an embodiment.

### DETAILED DESCRIPTION

Hereinafter, embodiments of a substrate processing system and a substrate abnormality detection method are described in detail with reference to the drawings. In addition, the disclosed substrate processing system and substrate abnormality detection method are not limited by the following embodiments.

Conventionally, a surface profile of a substrate has been measured to determine a quality of the substrate based on the surface profile. In such a determination based on the surface profile, for example, characteristic values such as a critical dimension (CD) and a thickness of a pattern formed on the substrate are measured as the surface profile by an ellipsometry, scanning electron microscope (SEM), or transmission electron microscope (TEM). The quality of the substrate is determined based on whether these surface profiles fall within a determination criteria range. However, measuring these surface profiles is time-consuming, making it impractical to perform such measurements for all substrates from the viewpoint of throughput. Therefore, when measured values necessary for determining the quality of the substrate, such as the surface profiles of the substrate, are unavailable, it becomes impossible to detect an abnormality in the substrate.

Therefore, there is a growing expectation for detection of the abnormality in the substrate even when the measured value of the surface profile of the substrate is unavailable.

### (Embodiments)

### [Configuration of Substrate Processing System 1]

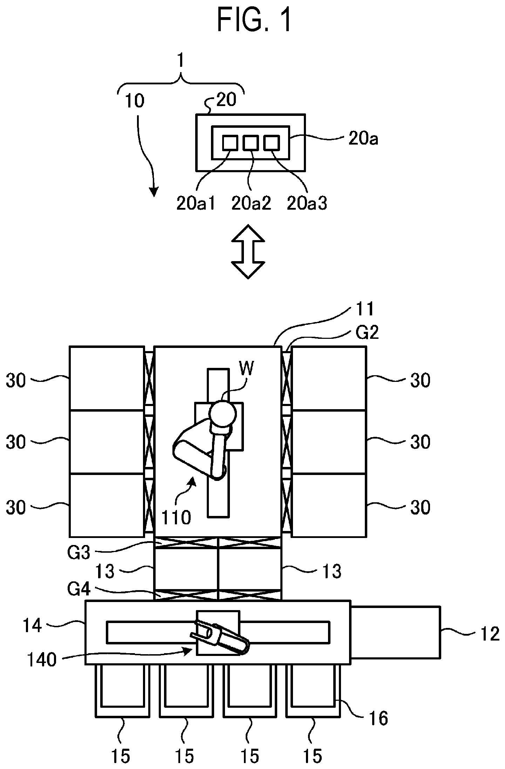

FIG. 1 is a system configuration diagram illustrating an example of a configuration of a substrate processing system 1 according to an embodiment. In FIG. 1, for convenience, certain apparatus internal components are illustrated as transparent. The substrate processing system 1 includes an apparatus main body 10, and a controller 20 that controls the apparatus main body 10.

The apparatus main body 10 includes a vacuum transfer module 11, an alignment module 12, a plurality of load lock modules 13, an atmospheric transfer module 14, and a plurality of processing modules 30.

The vacuum transfer module 11 is formed in a rectangular shape when viewed from above. The plurality of processing modules 30 are each connected to two longer sidewalls of the vacuum transfer module 11 via a gate valve G2.

Each processing module 30 is configured to be capable of performing substrate processing on a substrate W. In the present embodiment, each processing module 30 is configured to be capable of performing etching on the substrate W by using plasma. In addition, in FIG. 1, six processing modules 30 are connected to the vacuum transfer module 11, but the number of processing modules 30 connected to the vacuum transfer module 11 may be greater or fewer than six. In the present embodiment, each processing module 30 corresponds to a processing chamber of the present disclosure.

The plurality of load lock modules 13 are each connected to one shorter sidewall of the vacuum transfer module 11 via a gate valve G3. In FIG. 1, two load lock modules 13 are connected to the vacuum transfer module 11. The number of load lock modules 13 connected to the vacuum transfer module 11 may be greater or fewer than two.

A transfer robot 110 is disposed inside the vacuum transfer module 11. The transfer robot 110 transfers the substrate W between the load lock modules 13 and the processing modules 30. An interior of the vacuum transfer module 11 is maintained under a pressure atmosphere lower than atmospheric pressure.

Each load lock module 13 is connected to the vacuum transfer module 11 via the gate valve G3. Further, each load lock module 13 is connected to the atmospheric transfer module 14 via a gate valve G4 at a sidewall opposite to the sidewall connected to the vacuum transfer module 11. Once the substrate W is loaded from the atmospheric transfer module 14 into the load lock module 13 via the gate valve G4, the gate valve G4 is closed and an internal pressure of the load lock module 13 is lowered from atmospheric pressure to a predetermined pressure. Then, the gate valve G3 is opened, and the substrate W inside the load lock module 13 is unloaded into the vacuum transfer module 11 by the transfer robot 110.

Further, in a state where the internal pressure of the load lock module 13 is lower than atmospheric pressure, the substrate W is loaded from the vacuum transfer module 11 into the load lock module 13 via the gate valve G3 by the transfer robot 110, and the gate valve G3 is closed. Then, the internal pressure of the load lock module 13 is raised to atmospheric pressure. Then, the gate valve G4 is opened, and the substrate W inside the load lock module 13 is unloaded into the atmospheric transfer module 14.

The atmospheric transfer module 14 is provided with a plurality of load ports 15 on a sidewall opposite to the sidewall connected to the load lock modules 13. Further, the atmospheric transfer module 14 is also provided with the alignment module 12 at a sidewall different from both the sidewall connected to the load lock modules 13 and the sidewall provided with the load ports 15.

The alignment module 12 is configured to be capable of performing alignment of the substrate W. For example, the alignment module 12 includes a stage, which is rotatable by a motor and on which the substrate W is placed, and a sensor for detecting an outer circumference of the substrate W placed on the stage. The alignment module 12 detects a notch formed on the outer circumference of the substrate W by using the sensor, and rotates the stage so that a direction of the notch is aligned with a predetermined direction, thereby performing alignment of a rotational direction of the substrate W.

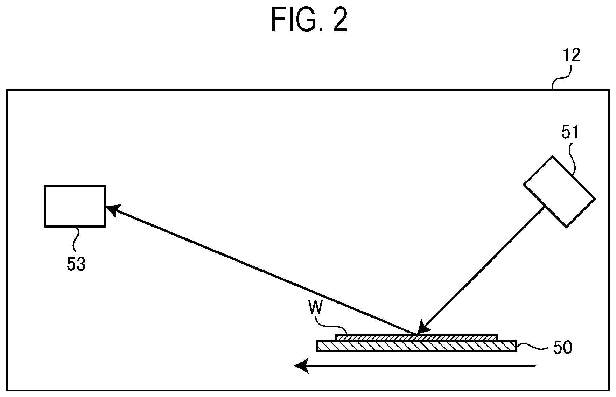

Further, the alignment module 12 is configured to be capable of measuring an in-plane spectral distribution of the substrate W. Herein, a configuration for measuring the in-plane spectral distribution of the substrate W in the alignment module 12 is described. FIG. 2 is a diagram illustrating the configuration for measuring the in-plane spectral distribution of the substrate W according to an embodiment. The alignment module 12 includes a stage 50. The substrate W is placed on the stage 50. The stage 50 is rotatable by a motor. Further, the stage 50 is configured to be slidable laterally by a slider (not illustrated).

A light source 51 that outputs light such as a light emitting diode (LED) is provided above the stage 50. The light source 51 is disposed so that an output light is incident on the stage 50 at a predetermined angle of incidence. The light output from the light source 51 is reflected by the substrate W on the stage 50. The reflected light from the substrate W is incident on a detector 53. The detector 53 is configured, for example, with a hyperspectral camera, and is capable of measuring for each wavelength a spectral distribution by hyperspectral light dispersion.

In the substrate processing system 1, the alignment module 12 outputs light from the light source 51 while moving the stage 50 with the substrate W placed thereon, and measures the spectral distribution of light reflected from the substrate W using the detector 53, thereby measuring the in-plane spectral distribution of the substrate W. This configuration allows the alignment module 12 to measure the in-plane spectral distribution of the substrate W within a short time. The detector 53 outputs data on the measured in-plane spectral distribution of the substrate W to the controller 20. In the present embodiment, the alignment module 12 corresponds to a measurer of the present disclosure. By providing the measurer capable of performing quick measurement on a transfer path of the substrate W in the substrate processing system 1, it becomes possible to inspect all substrates W.

A description continues, returning to FIG. 1. Each load port 15 is connected to a storage container 16 such as a front opening unified pod (FOUP) capable of accommodating a plurality of substrates W. An interior of the atmospheric transfer module 14 is at atmospheric pressure. The storage container 16 accommodates, for example, one lot of substrates W.

A transfer robot 140 is provided inside the atmospheric transfer module 14. The transfer robot 140 transfers the substrate W between the alignment module 12, the load lock modules 13, and the storage container 16 connected to the load port 15. A fan filter unit (FFU) or similar device is provided at a top of the atmospheric transfer module 14, and supplies air, from which particles and other contaminants have been removed, into the atmospheric transfer module 14 from above, forming a downflow inside the atmospheric transfer module 14. In addition, in the present embodiment, the atmospheric transfer module 14 is under an atmospheric atmosphere, but in another configuration, the interior of the atmospheric transfer module 14 may be controlled to be a positive pressure. This may prevent intrusion of particles and other contaminants into the atmosphere transfer module 14 from an outside.

The controller 20 processes computer-executable instructions that execute various steps described in the present disclosure in the apparatus main body 10. The controller 20 may be configured to control each element of the apparatus main body 10 so as to execute various steps described herein. In one embodiment, a part or all of the controller 20 may be included in the apparatus main body 10. The controller 20 may include a processor 20a1, a storage 20a2, and a communication interface 20a3. The controller 20 is realized, for example, by a computer 20a. The processor 20a1 may be configured to perform various control operations by reading a program from the storage 20a2 and executing the read program. This program may be stored in advance in the storage 20a2, or may be acquired via a medium when necessary. The acquired program is stored in the storage 20a2, and is read from the storage 20a2 to be executed by the processor 20a1. The medium may be any of various storage media readable by the computer 20a, or may be a communication line connected to the communication interface 20a3. The storage 20a2 stores not only the program but also recipes and data referenced during the execution of those recipes. The processor 20a1 may be a central processing unit (CPU). The storage 20a2 may include a random access memory (RAM), a read only memory (ROM), a hard disk drive (HDD), a solid state drive (SSD), or a combination thereof. The communication interface 20a3 may communicate with the apparatus main body 10 via a communication line such as a local area network (LAN). In the present embodiment, the controller 20 corresponds to a controller of the present disclosure.

### [Operation of Substrate Processing System 1]

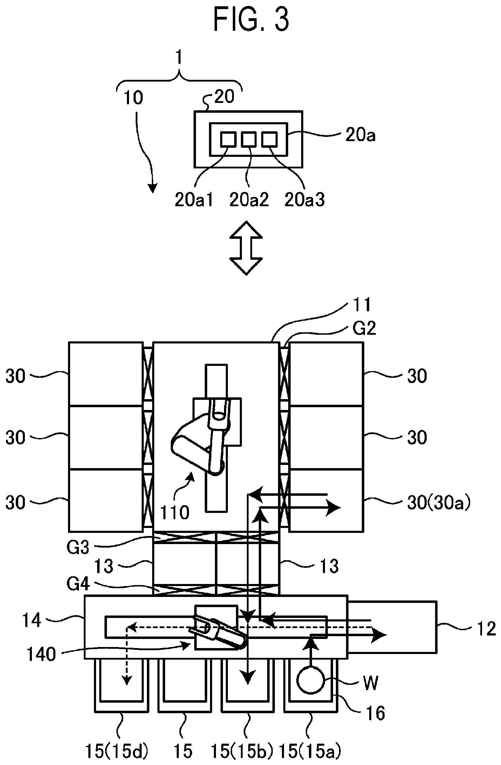

Next, an example of an operation in which the substrate processing system 1 of the embodiment transfers the substrate W between the storage container 16 and the processing module 30 and performs etching on the substrate W is described. FIG. 3 is a diagram illustrating an example of an operation during substrate processing by the substrate processing system 1 according to an embodiment. In FIG. 3, the substrate processing system 1 is illustrated. Herein, an operation in which the substrate processing system 1 transfers the substrate W accommodated in the storage container 16 attached to a rightmost load port 15a to a lower right processing module 30a and performs etching on the substrate W is described. In FIG. 3, a transfer path of the substrate W is represented by arrows. The solid arrows indicate a transfer path of a normal substrate W. The dashed arrows indicate a transfer path of a substrate W that is excluded from an etching target due to a detected abnormality in the substrate W.

The controller 20 controls the transfer robot 140 to take out the substrate W before the substrate processing from the storage container 16 at the load port 15a and to transfer the taken-out substrate W to the alignment module 12, placing it on the stage 50.

The controller 20 controls the alignment module 12 to perform positional alignment of the substrate W. The alignment module 12 detects the notch formed on the outer circumference of the substrate W by using the sensor (not illustrated), and rotates the stage 50 so that the direction of the notch is aligned with a predetermined direction, performing the alignment of the rotational direction of the substrate W.

Further, the controller 20 controls the alignment module 12 to measure the in-plane spectral distribution of the substrate W. The alignment module 12 outputs light from the light source 51 while moving the stage 50 with the substrate W placed thereon, and measures the spectral distribution of light reflected from the substrate W using the detector 53, thereby measuring the in-plane spectral distribution of the substrate W. The detector 53 outputs the data on the measured in-plane spectral distribution of the substrate W to the controller 20.

Once the alignment and the spectral distribution measurement are completed, the controller 20 controls the transfer robot 140 to take out the substrate W from the alignment module 12.

The data on the in-plane spectral distribution of the substrate W from the detector 53 is input to the controller 20. The controller 20 detects an abnormality in the substrate W from the in-plane spectral distribution of the substrate W measured by the detector 53 based on the data input from the detector 53. For example, the controller 20 creates an outlier detection model based on a portion of the in-plane spectral distribution of the substrate W, selected from the measured in-plane spectral distribution of the substrate W. Alternatively, the controller 20 may create an outlier detection model based on the entire measured in-plane spectral distribution of the substrate W. The controller 20 calculates an in-plane score of the substrate W from the measured in-plane spectral distribution of the substrate W by using the created outlier detection model. The controller 20 detects an abnormality in the substrate W based on the calculated score. Details of abnormality detection for detecting an abnormality in the substrate W is described later. In abnormality detection, it is detected whether there is an abnormality in the substrate W, and if there is an abnormality in the substrate W, it is determined whether correction of the abnormality is feasible.

When there is an abnormality in the substrate W and correction of the abnormality is infeasible, the controller 20 excludes the substrate W from the etching target and stores it in the storage container 16. For example, the controller 20 controls the transfer robot 140 to store the substrate W held by the transfer robot 140 in the storage container 16 at a leftmost load port 15d, as represented by the dashed arrows.

On the other hand, when there is no abnormality in the substrate W or if there is an abnormality in the substrate W but correction of the abnormality is feasible, the controller 20 transfers the substrate W to the processing module 30a to perform etching.

For example, the controller 20 opens the gate valve G4 of one of the load lock modules 13. The controller 20 controls the transfer robot 140 to transfer the substrate W held by the transfer robot 140 into and place it inside that load lock module 13. Once the transfer robot 140 retreats from the load lock module 13, the controller 20 closes the gate valve G4 of that load lock module 13.

The controller 20 controls an exhauster (not illustrated) of that load lock module 13 with the substrate W placed inside to exhaust indoor air, switching that load lock module 13 from an atmospheric atmosphere to a vacuum atmosphere.

The controller 20 then opens the gate valve G3 of that load lock module 13. The controller 20 controls the transfer robot 110 to hold the substrate W placed in that load lock module 13 and to transfer it to the vacuum transfer module 11. Once the transfer robot 110 retreats from that load lock module 13, the controller 20 closes the gate valve G3 of that load lock module 13. The controller 20 then opens the gate valve G2 of the processing module 30a. The controller 20 controls the transfer robot 110 to transfer the substrate W held by the transfer robot 110 into and place it inside the processing module 30a. Once the transfer robot 110 retreats from the processing module 30a, the controller 20 closes the gate valve G2 of the processing module 30a.

The controller 20 controls the processing module 30a to perform etching (substrate processing) on the substrate W.

Once the etching of the substrate W is completed, the controller 20 opens the gate valve G2 of the processing module 30a. The controller 20 controls the transfer robot 110 to take out the substrate W from the processing module 30a. Once the transfer robot 110 retreats from the processing module 30a, the controller 20 closes the gate valve G2 of the processing module 30a.

The controller 20 then opens the gate valve G3 of one of the load lock modules 13. The controller 20 controls the transfer robot 110 to transfer the substrate W after substrate processing, held by the transfer robot 110, into and place it inside that load lock module 13. Once the transfer robot 110 retreats from that load lock module 13, the controller 20 closes the gate valve G3 of that load lock module 13.

The controller 20 controls a suction device (not illustrated) of that load lock module 13 with the substrate W placed inside to supply, for example, clean air into the module, switching the load lock module 13 from a vacuum atmosphere to an atmospheric atmosphere.

The controller 20 then opens the gate valve G4 of that load lock module 13. The controller 20 controls the transfer robot 140 to take out the substrate W from that load lock module 13 and to store the taken-out substrate W in the storage container 16 at a second load port 15b from the right.

Further, although a case where the substrate processing system 1 transfers the substrate W to the processing module 30a to perform etching has been described by way of example, the substrate W may also be transferred to another processing module 30 for etching. Furthermore, the substrate W that has undergone etching may be transferred to, for example, another processing module 30 to undergo additional substrate processing in the another processing module 30.

### [Detection of Abnormality in Substrate W]

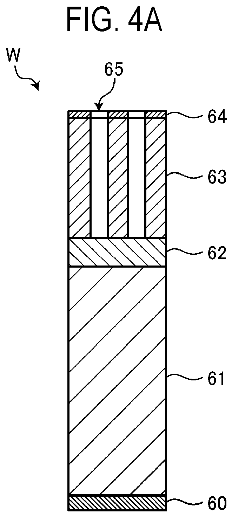

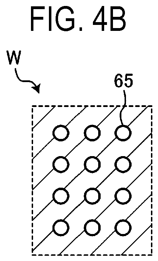

Herein, a specific example of detecting an abnormality in the substrate W is described. In the following, abnormality detection is performed using the substrate W with a configuration illustrated in FIGS. 4A and 4B as a test specimen. FIGS. 4A and 4B are diagrams illustrating an example of the configuration of the substrate W used as the test specimen according to an embodiment. FIG. 4A illustrates a cross section of the substrate W. FIG. 4B illustrates an enlarged top view of the substrate W. The substrate W includes an oxide layer 61, a nitride layer 62, a polysilicon layer 63, and a mask layer 64, which are sequentially formed on a silicon substrate 60 such as bare silicon from the bottom. The oxide layer 61 is, for example, a silicon oxide film. The nitride layer 62 is, for example, SiN. The mask layer 64 is, for example, tetraethoxysilane (TEOS). Holes 65 are formed in the polysilicon layer 63 and the mask layer 64. The holes 65 are disposed across an entire upper surface of the substrate W.

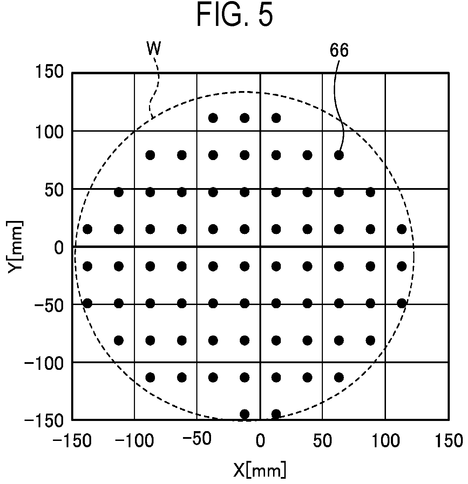

The controller 20 creates the outlier detection model based on the measured in-plane spectral distribution of the substrate W. For example, the controller 20 creates an outlier detection model based on a portion of the in-plane spectral distribution of the substrate W selected from the measured in-plane spectral distribution of the substrate W. For example, the controller 20 creates the outlier detection model based on a spectral distribution at a center within a plane of the substrate W. For example, a plurality of measurement points are defined on the upper surface of the substrate W. The measurement points may be disposed at least at the center and periphery of the substrate W, and may be distributed across on the entire upper surface of the substrate W. FIG. 5 is a diagram illustrating an example of disposition of measurement points 66 on the substrate W according to an embodiment. In FIG. 5, 70 measurement points 66 are disposed on the upper surface of the substrate W. In addition, if regions corresponding to semiconductor chips are divided and defined on the upper surface of the substrate W, the measurement points 66 may be positioned similar to the regions corresponding to semiconductor chips.

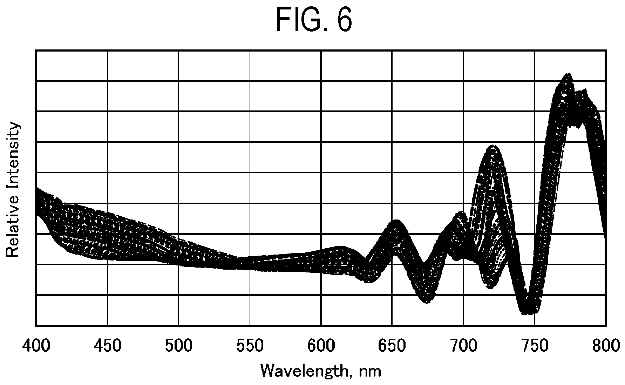

The controller 20 extracts a spectrum for each measurement point 66 on the upper surface of the substrate W from the data input by the detector 53. FIG. 6 is a diagram illustrating an example of the spectrum for each measurement point 66 on the substrate W according to an embodiment. In FIG. 6, spectra for all 70 measurement points 66 illustrated in FIG. 5 are overlaid. As illustrated in FIG. 6, the spectra for the 70 measurement points 66 exhibit a waveform difference. A waveform width of the spectra for the 70 measurement points 66 represents a difference in the in-plane profile (surface shape) of the substrate W.

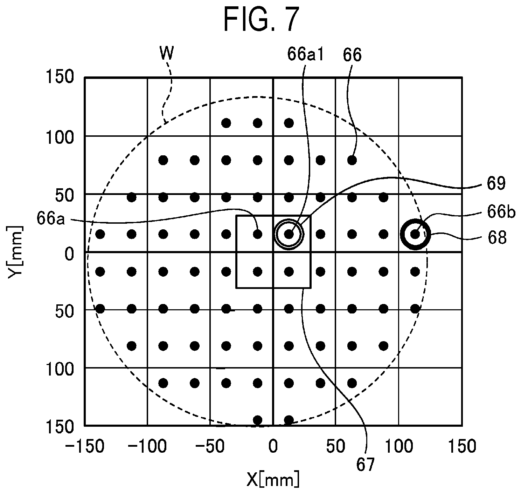

Herein, a spectrum for the measurement point 66 at the center within the plane of the substrate W and a spectrum for the measurement point 66 at the periphery of the substrate W are compared. FIG. 7 is a diagram illustrating an example of center measurement points 66 and periphery measurement points 66 on the substrate W according to an embodiment. In FIG. 7, four center measurement points 66a on the center of the substrate W are enclosed by line 67, and the periphery measurement points 66b are enclosed by line 68.

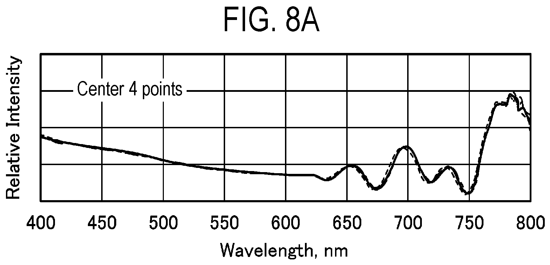

FIG 8A is a diagram illustrating an example of spectra for the center measurement points 66 on the substrate W according to an embodiment. In FIG. 8A, spectra for the four measurement points 66a enclosed by line 67 in FIG. 7 are illustrated, respectively. The spectra for the four measurement points 66a at the center exhibit almost no difference in waveform. From this, it may be inferred that there is almost no difference in profile among the four measurement points 66a at the center.

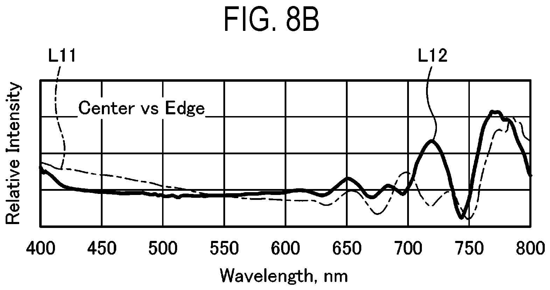

FIG 8B is a diagram illustrating an example of spectra for the center measurement point 66 and the periphery measurement point 66 on the substrate W according to an embodiment. In FIG. 8B, a spectrum for a measurement point 66a1 enclosed by line 69, among the four center measurement points 66a illustrated in FIG. 7, is represented by line L11. Further, in FIG. 8B, a spectrum for the measurement point 66b enclosed by line 68 on the periphery of the substrate W illustrated in FIG. 7 is represented by line L12. The spectrum (line L11) for the center measurement point 66a1 and the spectrum (line L12) for the periphery measurement point 66b on the substrate W exhibit a waveform difference. From this, it may be inferred that there is a difference in profile between the center and periphery of the substrate W.

The controller 20 creates an outlier detection model based on a spectral distribution at the center within the plane of the substrate W. For example, the controller 20 creates the outlier detection model from the spectra for the four measurement points 66a on the center of the substrate W enclosed by line 67 in FIG. 7. Examples of the outlier detection model may include a local outlier factor (LOF), k-nearest neighbor method, and one-class support vector machine (SVM), etc. The LOF is an algorithm designed to identify outliers within a certain data set. The outlier detection model utilizes the spectra for the four measurement points 66a at the center as reference data to calculate a difference indicating a degree of deviation from the reference data as a score.

The controller 20 calculates the in-plane score of the substrate W from the measured in-plane spectral distribution of the substrate W by using the created outlier detection model. For example, the controller 20 inputs each of spectra for all the measurement points 66 into the outlier detection model, and calculates the difference from reference data as a score.

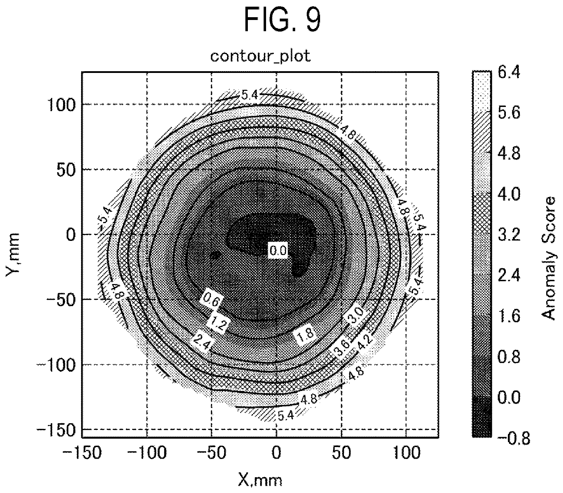

FIG. 9 is a diagram illustrating an example of an in-plane score distribution of the substrate W according to an embodiment. FIG. 9 illustrates a result of calculating a score for each measurement point within the plane of the substrate W by using the outlier detection model, and obtaining the in-plane score distribution of the substrate W by interpolation using the calculated score. In the substrate W illustrated in FIG. 9, the score is smaller at the center and increases outward. From this, it may be inferred that there is a difference in profile between the center and periphery of the substrate W.

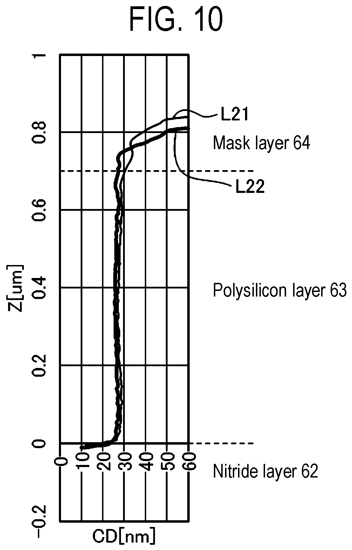

Herein, a cross-sectional profile of the substrate W used as the test specimen, which is measured based on an SEM image of the cross-section of the substrate W captured using a scanning electron microscope (SEM), is described. FIG. 10 is a diagram illustrating an example of the profile of the substrate W according to an embodiment. In FIG. 10, a profile at the center measurement point 66a1 illustrated in FIG. 7 is represented by line L21. Line L21 indicates an average surface shape of a plurality of holes 65 by using a CD average value for each depth of the holes 65 included in the measurement point 66a1. Further, in FIG. 10, a profile at the periphery measurement point 66b on the substrate W illustrated in FIG. 7 is represented by line L22. Line L22 indicates an average surface profile of the plurality of holes 65 by using a CD average value for each depth of the holes 65 included in the measurement point 66b. Further, in FIG. 10, ranges of the nitride layer 62, polysilicon layer 63, and mask layer 64 are illustrated. The profile (line L21) at the center measurement point 66a1 on the substrate W and the profile (line L22) at the periphery measurement point 66b differ at the top, particularly exhibiting a difference in shape at the mask layer 64.

From this, it may be confirmed that the score calculated using the outlier detection model indicates a variation in the profile at each measurement point relative to the profile at the center of the substrate W, which serves as a reference.

The controller 20 detects an abnormality in the substrate W based on the calculated score. For example, the controller 20 calculates a difference between the score at the center and the score at the periphery of the substrate W as an anomaly score indicating a degree of abnormality for each substrate W. For example, the controller 20 calculates the anomaly score for each substrate W as (a score average value at the center of the substrate W) minus (a score average value at an outermost periphery of the substrate W).

The controller 20 detects the substrate W as abnormal if the anomaly score is equal to or greater than a threshold, and as normal if the anomaly score is less than the threshold. The threshold may be determined in advance. Further, the threshold may be dynamically set. For example, the threshold may be dynamically set by correlating the actually measured anomaly score of the substrate W with a cross-sectional analysis or an electrical characteristic of the substrate W after processing.

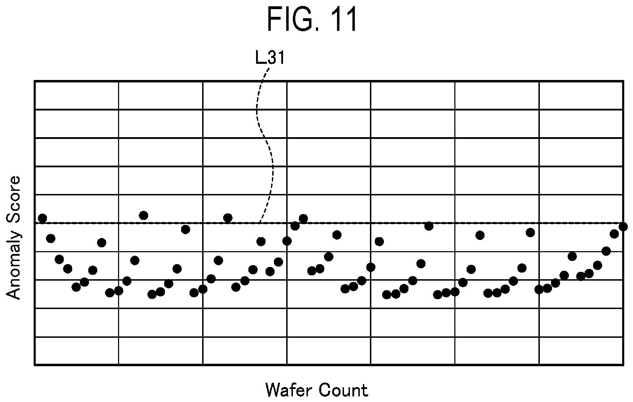

FIG. 11 is a diagram illustrating an example of the anomaly score for each substrate W according to an embodiment. In FIG. 11, substrates W are sequentially numbered (Wafer Count), and the anomaly score (Anomaly Score) for each numbered substrate W is illustrated. Further, in FIG. 11, a threshold is represented by line L31. In FIG. 11, the substrate W with the anomaly score equal to or greater than line L31 is determined as being abnormal.

The controller 20 transfers the normal substrate W with no detected abnormality to the processing module 30 and controls the processing module 30 to perform etching on the substrate W.

On the other hand, the controller 20 determines whether correction is feasible for the substrate W with a detected abnormality. For example, the controller 20 inputs the anomaly score of the substrate W with the detected abnormality into a control model, which determines whether correction is feasible. The control model is a learned model that determines, for each anomaly score, whether correction is feasible, and if so, calculates a correction amount of a processing condition of the processing module 30 required to improve uniformity of the in-plane profile of the substrate W.

The controller 20 inputs the anomaly score of the substrate W with the detected abnormality into the control model. When the control model outputs a result indicating that correction is infeasible, the controller 20 excludes the substrate W determined as being uncorrectable from the etching target and stores it in the storage container 16. For example, as illustrated in FIG. 3, the controller 20 stores the substrate W determined as being uncorrectable in the storage container 16 of the leftmost load port 15d.

On the other hand, when the control model outputs a result indicating that correction is feasible, the controller 20 transfers the correctable substrate W to the processing module 30. Then, the controller 20 corrects the processing condition based on the correction amount obtained from the control model and controls the processing module 30 to perform etching on the substrate W under the corrected processing condition.

In this way, the substrate processing system 1 according to the embodiment is configured such that the alignment module 12 measures the in-plane spectral distribution of the substrate W. The controller 20 creates the outlier detection model based on the measured in-plane spectral distribution of the substrate W. For example, the substrate processing system 1 creates the outlier detection model based on a portion of the in-plane spectral distribution of the substrate W selected from the measured in-plane spectral distribution of the substrate W. The substrate processing system 1 calculates the in-plane score of the substrate W from the measured in-plane spectral distribution of the substrate W by using the created outlier detection model, and detects an abnormality in the substrate W based on the calculated score. Thus, the substrate processing system 1 may detect an abnormality in the substrate W even when a measured value of the surface profile of the substrate W, such as substrate pattern information, is unavailable. Herein, measurement of the surface profile of the pattern formed on the substrate W requires a lengthy measurement time, making a full inspection infeasible from the viewpoint of throughput. The substrate processing system 1 is capable of performing a full inspection for an abnormality in the substrate W even when a measured value of the surface profile of the substrate W is unavailable. Further, the substrate processing system 1 is capable of monitoring fluctuations within the plane of the substrate W before the etching. Further, the substrate processing system 1 is capable of monitoring fluctuations within a lot of substrates W before the etching by comparing the calculated score of each of the substrates W.

### [Substrate Abnormality Detection Method]

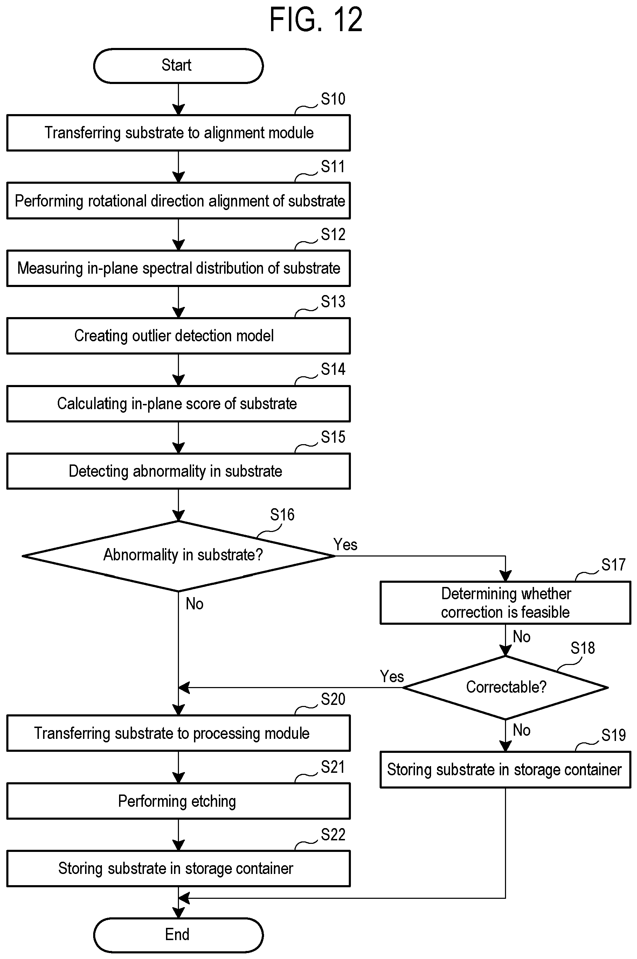

FIG. 12 is a flowchart illustrating an example of a substrate processing flow including processing of a substrate abnormality detection method according to an embodiment. The processing illustrated in FIG. 12 is realized by the controller 20, which reads a program from the storage 20a2, executes the read program, and controls each component of the apparatus main body 10 via the communication interface 20a3. The processing illustrated in FIG. 12 is executed, for example, for each substrate W accommodated in the storage container 16 at the load port 15a.

The controller 20 controls the transfer robot 140 to transfer the substrate W to the alignment module 12 (S10). The controller 20 controls the alignment module 12 to perform alignment of a rotational position of the substrate W (S11). Further, the controller 20 controls the alignment module 12 to measure the in-plane spectral distribution of the substrate W (S12). For example, the alignment module 12 outputs light from the light source 51 while moving the stage 50 with the substrate W placed thereon, and measures the spectral distribution of light reflected from the substrate W using the detector 53, thereby measuring the in-plane spectral distribution of the substrate W. The detector 53 outputs the data on the measured in-plane spectral distribution of the substrate W to the controller 20.

The controller 20 creates the outlier detection model based on the in-plane spectral distribution of the substrate W derived from the data input from the detector 53 (S13). For example, the controller 20 creates an outlier detection model based on a portion of the in-plane spectral distribution of the substrate W selected from the in-plane spectral distribution of the substrate W derived from the data input from the detector 53. For example, the controller 20 creates the outlier detection model based on a spectral distribution at the center within the plane of the substrate W.

The controller 20 calculates the in-plane score of the substrate W from the measured in-plane spectral distribution of the substrate W by using the created outlier detection model (S14).

The controller 20 detects an abnormality in the substrate W based on the calculated score (S15). For example, the controller 20 calculates the difference between the score at the center and the score at the periphery of the substrate W as the anomaly score. The controller 20 detects that the substrate W is anomalous if the anomaly score is equal to or greater than a threshold.

The controller 20 determines whether an abnormality in the substrate W is detected (S16). If an abnormality is detected (S16: "Yes"), the controller 20 inputs the anomaly score of the substrate W with the detected abnormality into the control model, which determines whether correction is feasible (S17).

The controller 20 determines whether the determination result is that correction is feasible (S18). If the determination result is that correction is infeasible (S18: "No"), the controller 20 excludes the substrate W determined as being uncorrectable from the etching target and stores it in the storage container 16 (S19). For example, as illustrated in FIG. 3, the controller 20 stores the substrate W in the storage container 16 at the load port 15d.

On the other hand, if no abnormality is detected (S16: "No") or if the determination result is that correction is feasible (S18: "Yes"), the controller 20 controls the transfer robots 110 and 140, gate valves G2 to G4, and other related components to transfer the substrate W to the processing module 30 (S20). The controller 20 controls the processing module 30a to perform the etching on the substrate W (S21). Further, if an abnormality is detected in the substrate W but is determined that correction is feasible, the controller 20 corrects the processing condition by using the correction amount obtained from the control model, and controls the processing module 30a to perform the etching on the substrate W under the corrected processing condition.

After the etching of the substrate W is completed, the controller 20 controls the transfer robots 110 and 140, gate valves G2 to G4, and other related components to store the substrate W in the storage container 16 (S22), and concludes the processing illustrated in this flowchart. For example, the controller 20 stores the substrate W in the storage container 16 at the load port 15b, as illustrated in FIG. 3.

In addition, in the above embodiments, a case where an abnormality in the substrate W is detected based on the spectral distribution of the substrate W before the etching has been described by way of example. However, the present disclosure is not limited to this. The substrate processing system 1 may measure a spectral distribution of the substrate W after the etching, and may detect an abnormality in the substrate W based on the spectral distribution of the substrate W after the etching. For example, the controller 20 controls the processing module 30 to transfer the completely etched substrate W to the alignment module 12, and controls the alignment module 12 to measure the spectral distribution of the substrate W, and then transfer the substrate W to the storage container 16. The controller 20 may detect an abnormality in the substrate W based on the spectral distribution of the substrate W after the etching derived from the data input from the detector 53. For example, the controller 20 creates an outlier detection model based on the in-plane spectral distribution of the substrate W after the etching. For example, the controller 20 creates an outlier detection model based on a portion of the in-plane spectral distribution of the substrate W selected from the in-plane spectral distribution of the substrate W after the etching. For example, the controller 20 creates the outlier detection model based on a spectral distribution at the center within the plane of the substrate W. Then, the controller 20 may calculate the in-plane score of the substrate W from the measured in-plane spectral distribution of the substrate W after the etching by using the created outlier detection model, and may detect an abnormality in the substrate W after the etching based on the calculated score. For example, the controller 20 detects an abnormality in the substrate W based on a difference between the score at the center of the substrate W and the score at the periphery of the substrate W. Thus, the substrate processing system 1 may detect an abnormality in the substrate W after the etching even when a measured value of a surface profile of the substrate W after the etching is unavailable. Further, the substrate processing system 1 may monitor fluctuations within the plane of the substrate W after the etching. Further, the substrate processing system 1 may monitor fluctuations in a lot of substrates W after the etching by comparing the calculated score of each of the substrates W. Further, the substrate processing system 1 may monitor a difference in etching rate between the center and the periphery based on the difference between the score at the center of the substrate W and the score at the periphery of the substrate W. The substrate W experiences tilting or non-uniformity of the critical dimension (CD) value in the holes 65 in a region where there is a significant etching rate difference. Therefore, the substrate processing system 1 may predict the occurrence of tilting or non-uniformity of the critical dimension (CD) value by monitoring the difference in the etching rate between the center and periphery of the substrate W.

Further, the substrate processing system 1 may measure the spectral distribution of the substrate W both before and after the etching, and may detect an abnormality in the substrate W based on the spectral distribution of the substrate W both before and after the etching. For example, the substrate processing system 1 measures the spectral distribution of the substrate W before the etching, as described in the above embodiments. Further, the controller 20 controls the processing module 30 to transfer the completely etched substrate W to the alignment module 12, and controls the alignment module 12 to measure the spectral distribution of the substrate W, and then transfer the substrate W to the storage container 16. The controller 20 may detect an abnormality in the substrate W based on both the spectral distribution of the substrate W before the etching and the spectral distribution of the substrate W after the etching, which are derived from the data input from the detector 53. For example, the controller 20 creates an outlier detection model based on each of the in-plane spectral distribution of the substrate W before the etching and the in-plane spectral distribution of the substrate W after the etching. For example, the controller 20 creates an outlier detection model based on a portion of the in-plane spectral distribution of the substrate W selected from each of the in-plane spectral distribution of the substrate W before the etching and the in-plane spectral distribution of the substrate W after the etching. For example, the controller 20 calculates a difference spectral distribution indicating a difference between the in-plane spectral distribution of the substrate W before the etching and the in-plane spectral distribution of the substrate W after the etching. For example, the controller 20 calculates the difference spectral distribution indicating the difference between the in-plane spectral distribution of the substrate W before the etching and the in-plane spectral distribution of the substrate W after the etching for each wavelength. Then, the controller 20 creates an outlier detection model based on the calculated difference spectral distribution. For example, the controller 20 creates an outlier detection model based on a portion of the in-plane spectral distribution of the substrate W selected from the calculated difference spectral distribution. For example, the controller 20 creates the outlier detection model based on the spectral distribution at the center within the plane of the substrate W. Then, the controller 20 calculates a score from the in-plane spectral distribution of the substrate W before the etching and the in-plane spectral distribution of the substrate W after the etching by using the created outlier detection model. For example, the controller 20 calculates an in-plane score of the substrate W based on the difference spectral distribution by using the created outlier detection model. The controller 20 detects an abnormality in the substrate W based on the calculated score. Thus, the substrate processing system 1 may detect an abnormality in the etching of the substrate W even when a measured value of the surface profile of the substrate W related to film changes due to the etching is unavailable. Further, the substrate processing system 1 may monitor fluctuations within the plane of the substrate W before and after the etching. Further, the substrate processing system 1 may monitor fluctuations in a lot of substrates W before and after the etching by comparing the calculated score of each of the substrates W. Further, the in-plane spectrum of the substrate W before the etching correlates with the in-plane profile of the substrate W before the etching. The in-plane spectrum of the substrate W after the etching correlates with the in-plane profile of the substrate W after the etching. Therefore, the difference between the in-plane spectrum of the substrate W before the etching and the in-plane spectrum of the substrate W after the etching correlates with the etching rate. Therefore, the substrate processing system 1 may more accurately monitor the difference in the etching rate between the center and periphery of the substrate W by calculating the difference spectral distribution, and may predict tilting and non-uniformity of the critical dimension (CD) value with high accuracy.

Further, in the above embodiments, a case where the alignment module 12 performs alignment as well as spectral distribution measurement of the substrate W has been described by way of example. However, the present disclosure is not limited to this. The substrate processing system 1 may perform the spectral distribution measurement of the substrate W in parts other than the alignment module 12. For example, the substrate processing system 1 may be further provided with a measurement module having a configuration capable of measuring the spectral distribution of the substrate W as illustrated in FIG. 2, and may transfer the substrate W to the measurement module, where the spectral distribution of the substrate W is measured. Further, the substrate processing system 1 may provide a configuration capable of measuring the spectral distribution of the substrate W as illustrated in FIG. 2 to components such as the vacuum transfer module 11, load lock modules 13, and atmospheric transfer module 14, where the spectral distribution of the substrate W is measured.

Further, in the above embodiments, a case where the in-plane spectral distribution of the substrate W is measured for each substrate W, and the outlier detection model is created for each substrate W based on the measured in-plane spectral distribution of the substrate W has been described by way of example. However, the present disclosure is not limited to this. The outlier detection model may be created by measuring the in-plane spectral distribution of a specific substrate W to enable the creation of the model based on the in-plane spectral distribution of the specific substrate W. For the substrate W other than the specific substrate W, a score may be calculated using the outlier detection model created for the specific substrate W. The specific substrate W may be, for example, the substrate W that is first taken out from the storage container 16, the substrate W belonging to a predetermined lot, or the substrate W that is first processed by the substrate processing system 1 after startup or maintenance.

Further, in the above embodiments, a case where each processing module 30 performs the etching on the substrate W as the substrate processing has been described by way of example. However, the present disclosure is not limited to this. The substrate processing performed by each processing module 30 may be film formation, ashing, or any other type of processing for the substrate W.

In the above, the embodiments have been described. As described above, the substrate processing system 1 according to the embodiments includes the load port 15, the processing module 30 (processing chamber), the alignment module 12 (measurer), and the controller 20 (controller). The load port 15 is configured to be connectable to the storage container 16 that accommodates the substrate W. The processing module 30 is configured to perform the substrate processing on the substrate W. The alignment module 12 is provided on a transfer path for the substrate W between the storage container 16 and the processing module 30, and is configured to measure the in-plane spectral distribution of the substrate W. The controller 20 is configured to create the outlier detection model based on the in-plane spectral distribution of the substrate W measured by the alignment module 12, to calculate the in-plane score of the substrate W from the measured in-plane spectral distribution of the substrate W by using the created outlier detection model, and to detect an abnormality in the substrate W based on the calculated score. Thus, the substrate processing system 1 may detect an abnormality in the substrate W even when a measured value of the surface profile of the substrate W is unavailable.

In general, fluctuations in an internal state of the processing module 30 (processing chamber) leads to fluctuations in the quality of the etched substrate W. Further, if there are fluctuations in the quality of the substrate W before the substrate processing, it adversely affects the quality of the substrate W after the substrate processing.

Further, the alignment module 12 is configured to measure the in-plane spectral distribution of the substrate W before the substrate processing as the substrate is transferred from the storage container 16 to the processing module 30. The controller 20 is configured to create the outlier detection model based on the measured in-plane spectral distribution of the substrate W before the substrate processing, to calculate the in-plane score of the substrate W from the measured in-plane spectral distribution of the substrate W before the substrate processing by using the created outlier detection model, and to detect an abnormality in the substrate W before the substrate processing based on the calculated score. Thus, the substrate processing system 1 may detect an abnormality in the substrate W before the substrate processing even when a measured value of the surface profile of the substrate W before the substrate processing is unavailable.

Further, the alignment module 12 is configured to measure the in-plane spectral distribution of the substrate W after the substrate processing as the substrate is transferred from the processing module 30 to the storage container 16. The controller 20 is configured to create the outlier detection model based on the measured in-plane spectral distribution of the substrate W after the substrate processing, to calculate the in-plane score of the substrate W from the measured in-plane spectral distribution of the substrate W after the substrate processing by using the created outlier detection model, and to detect an abnormality in the substrate W after the substrate processing based on the calculated score. Thus, the substrate processing system 1 may detect an abnormality in the substrate W after the substrate processing even when a measured value of the surface profile of the substrate W after the substrate processing is unavailable.

Further, the alignment module 12 is configured to measure the in-plane spectral distribution of the substrate W before the substrate processing as the substrate is transferred from the storage container 16 to the processing module 30, and the in-plane spectral distribution of the substrate W after the substrate processing as the substrate is transferred from the processing module 30 to the storage container 16. The controller 20 is configured to create the outlier detection model based on each of the in-plane spectral distribution of the substrate W before the substrate processing and the in-plane spectral distribution of the substrate W after the substrate processing, as measured by the alignment module 12, to calculate the in-plane score of the substrate W from the in-plane spectral distribution of the substrate W before the substrate processing and the in-plane spectral distribution of the substrate W after the substrate processing by using the created outlier detection model, and to detect an abnormality in the substrate W based on the calculated score. Thus, the substrate processing system 1 may detect an abnormality in the substrate W before and after the substrate processing even when a measured value of the surface profile of the substrate W is unavailable.

Further, the controller 20 is configured to calculate the difference spectral distribution indicating the difference between the in-plane spectral distribution of the substrate W before the substrate processing and the in-plane spectral distribution of the substrate W after the substrate processing, as measured by the alignment module 12, to create the outlier detection model based on the calculated difference spectral distribution, to calculate the in-plane score of the substrate W from the difference spectral distribution by using the created outlier detection model, and to detect an abnormality in the substrate W based on the calculated score. Thus, the substrate processing system 1 may detect an abnormality in the substrate processing of the substrate W even when a measured value of the surface profile related to changes in the substrate W due to substrate processing is unavailable.

Further, the controller 20 is configured to create the outlier detection model based on a portion of the in-plane specific spectral distribution of the substrate W. Thus, the substrate processing system 1 may calculate the score indicating the degree of deviation of the spectral distribution on the basis of a portion of the in-plane spectral distribution of the substrate W by using the created outlier detection model.

Further, the controller 20 is configured to create the outlier detection model based on the spectral distribution at the center within the plane of the substrate W. Thus, the substrate processing system 1 may calculate the score indicating the degree of deviation of the spectral distribution on the basis of the spectral distribution at the center within the plane of the substrate W by using the created outlier detection model.

Further, the controller 20 is configured to detect an abnormality in the substrate W based on the difference between the score at the center of the substrate W and the score at the periphery of the substrate W. Thus, the substrate processing system 1 may detect an abnormality in the substrate W based on the difference in the profile between the center and the periphery within the plane of the substrate W.

Further, the controller 20 is configured to adjust the processing condition in the processing module 30 for the substrate W with the detected abnormality based on the score of that substrate W. Thus, the substrate processing system 1 may improve uniformity of the in-plane profile of the substrate W with the detected abnormality by performing the substrate processing on the substrate W with the detected abnormality under the adjusted processing condition.

In addition, the embodiments disclosed herein should be considered to be exemplary and not limitative in all respects. In fact, the above embodiments may be implemented in various forms. Further, the above embodiments may be omitted, replaced, or modified in various ways without departing from the scope of the appended claims.

Hereinafter, the above embodiments are additionally described as supplementary notes.

### (Supplementary Note 1)

A substrate processing system including:
a load port configured to be connectable to a storage container that accommodates a substrate;
a processing chamber configured to perform substrate processing on the substrate;
a measurer provided on a transfer path of the substrate between the storage container and the processing chamber and configured to measure an in-plane spectral distribution of the substrate; and
a controller configured to create an outlier detection model based on the in-plane spectral distribution of the substrate measured by the measurer, to calculate an in-plane score of the substrate from the measured in-plane spectral distribution of the substrate by using the created outlier detection model, and to detect an abnormality in the substrate based on the calculated score.

### (Supplementary Note 2)

The substrate processing system of Supplementary Note 1, wherein the measurer is configured to measure an in-plane spectral distribution of the substrate before the substrate processing as the substrate is transferred from the storage container to the processing chamber, and
wherein the controller is configured to create an outlier detection model based on the measured in-plane spectral distribution of the substrate before the substrate processing, to calculate an in-plane score of the substrate from the measured in-plane spectral distribution of the substrate before the substrate processing by using the created outlier detection model, and to detect an abnormality in the substrate before the substrate processing based on the calculated score.

### (Supplementary Note 3)

The substrate processing system of Supplementary Note 1, wherein the measurer is configured to measure an in-plane spectral distribution of the substrate after the substrate processing as the substrate is transferred from the processing chamber to the storage container, and
wherein the controller is configured to create an outlier detection model based on the measured in-plane spectral distribution of the substrate after the substrate processing, to calculate an in-plane score of the substrate from the measured in-plane spectral distribution of the substrate after the substrate processing by using the created outlier detection model, and to detect an abnormality in the substrate after the substrate processing based on the calculated score.

### (Supplementary Note 4)

The substrate processing system of Supplementary Note 1, wherein the measurer is configured to measure an in-plane spectral distribution of the substrate before the substrate processing as the substrate is transferred from the storage container to the processing chamber, and an in-plane spectral distribution of the substrate after the substrate processing as the substrate is transferred from the processing chamber to the storage container, and
wherein the controller is configured to create an outlier detection model based on each of the in-plane spectral distribution of the substrate before the substrate processing and the in-plane spectral distribution of the substrate after the substrate processing, as measured by the measurer, to calculate an in-plane score of the substrate from the in-plane spectral distribution of the substrate before the substrate processing and the in-plane spectral distribution of the substrate after the substrate processing by using the created outlier detection model, and to detect an abnormality in the substrate based on the calculated score.

### (Supplementary Note 5)

The substrate processing system of Supplementary Note 4, wherein the controller is configured to calculate a difference spectral distribution indicating a difference between the in-plane spectral distribution of the substrate before the substrate processing and the in-plane spectral distribution of the substrate after the substrate processing, as measured by the measurer, to create an outlier detection model based on the calculated difference spectral distribution, to calculate an in-plane score of the substrate from the difference spectral distribution by using the created outlier detection model, and to detect an abnormality in the substrate based on the calculated score.

### (Supplementary Note 6)

The substrate processing system of any one of Supplementary Notes 1 to 5, wherein the controller is configured to create an outlier detection model based on a portion of the in-plane spectral distribution of the substrate.

### (Supplementary Note 7)

The substrate processing system of any one of Supplementary Notes 1 to 5, wherein the controller is configured to create an outlier detection model based on a spectral distribution at a center within a plane of the substrate.

### (Supplementary Note 8)

The substrate processing system of any one of Supplementary Notes 1 to 7, wherein the controller is configured to detect an abnormality in the substrate based on a difference between a score at a center of the substrate and a score at a periphery of the substrate.

### (Supplementary Note 9)

The substrate processing system of any one of Supplementary Notes 1 to 8, wherein the controller is configured to adjust a processing condition in the processing chamber for the substrate with the detected abnormality based on the score of that substrate.

### (Supplementary Note 10)

The substrate processing system of any one of Supplementary Notes 1 to 9, wherein the outlier detection model is one of a local outlier factor (LOF) model, k-nearest neighbor method, and one-class support vector machine (SVM).

### (Supplementary Note 11)

A substrate abnormality detection method including:
measuring an in-plane spectral distribution of a substrate by a measurer provided on a transfer path of the substrate between a storage container disposed on a load port to accommodate the substrate and a processing chamber configured to perform substrate processing on the substrate;
creating an outlier detection model based on the measured in-plane spectral distribution of the substrate;
calculating an in-plane score of the substrate from the measured in-plane spectral distribution of the substrate by using the created outlier detection model; and
detecting an abnormality in the substrate based on the calculated score.

### EXPLANATION OF REFERENCE NUMERALS

G2 to G4: gate valve, W: substrate, 1: substrate processing system, 10: apparatus main body, 11: vacuum transfer module, 110: transfer robot, 12: alignment module, 13: load lock module, 14: atmospheric transfer module, 140: transfer robot, 15, 15a, 15b, 15d: load port, 20: controller, 20a: computer, 20a1: processor, 20a2: storage, 20a3: communication interface, 30, 30a: processing module, 50: stage, 51: light source, 53: detector, 60: silicon substrate, 61: oxide layer, 62: nitride layer, 63: polysilicon layer, 64: mask layer, 65: hole, 66, 66a, 66a1, 66b: measurement point

## Claims

1. A substrate processing system comprising:
a load port configured to be connectable to a storage container that accommodates a substrate;
a processing chamber configured to perform substrate processing on the substrate;
a measurer provided on a transfer path of the substrate between the storage container and the processing chamber and configured to measure an in-plane spectral distribution of the substrate; and
a controller configured to create an outlier detection model based on the in-plane spectral distribution of the substrate measured by the measurer, to calculate an in-plane score of the substrate from the measured in-plane spectral distribution of the substrate by using the created outlier detection model, and to detect an abnormality in the substrate based on the calculated score.

2. The substrate processing system of Claim 1, wherein the measurer is configured to measure an in-plane spectral distribution of the substrate before the substrate processing as the substrate is transferred from the storage container to the processing chamber, and
wherein the controller is configured to create an outlier detection model based on the measured in-plane spectral distribution of the substrate before the substrate processing, to calculate an in-plane score of the substrate from the measured in-plane spectral distribution of the substrate before the substrate processing by using the created outlier detection model, and to detect an abnormality in the substrate before the substrate processing based on the calculated score.

3. The substrate processing system of Claim 1, wherein the measurer is configured to measure an in-plane spectral distribution of the substrate after the substrate processing as the substrate is transferred from the processing chamber to the storage container, and
wherein the controller is configured to create an outlier detection model based on the measured in-plane spectral distribution of the substrate after the substrate processing, to calculate an in-plane score of the substrate from the measured in-plane spectral distribution of the substrate after the substrate processing by using the created outlier detection model, and to detect an abnormality in the substrate after the substrate processing based on the calculated score.

4. The substrate processing system of Claim 1, wherein the measurer is configured to measure an in-plane spectral distribution of the substrate before the substrate processing as the substrate is transferred from the storage container to the processing chamber, and an in-plane spectral distribution of the substrate after the substrate processing as the substrate is transferred from the processing chamber to the storage container, and
wherein the controller is configured to create an outlier detection model based on each of the in-plane spectral distribution of the substrate before the substrate processing and the in-plane spectral distribution of the substrate after the substrate processing, as measured by the measurer, to calculate an in-plane score of the substrate from the in-plane spectral distribution of the substrate before the substrate processing and the in-plane spectral distribution of the substrate after the substrate processing by using the created outlier detection model, and to detect an abnormality in the substrate based on the calculated score.

5. The substrate processing system of Claim 4, wherein the controller is configured to calculate a difference spectral distribution indicating a difference between the in-plane spectral distribution of the substrate before the substrate processing and the in-plane spectral distribution of the substrate after the substrate processing, as measured by the measurer, to create an outlier detection model based on the calculated difference spectral distribution, to calculate an in-plane score of the substrate from the difference spectral distribution by using the created outlier detection model, and to detect an abnormality in the substrate based on the calculated score.

6. The substrate processing system of Claim 1, wherein the controller is configured to create an outlier detection model based on a portion of the in-plane spectral distribution of the substrate.

7. The substrate processing system of Claim 1, wherein the controller is configured to create an outlier detection model based on a spectral distribution at a center within a plane of the substrate.

8. The substrate processing system of Claim 1, wherein the controller is configured to detect an abnormality in the substrate based on a difference between a score at a center of the substrate and a score at a periphery of the substrate.

9. The substrate processing system of Claim 1, wherein the controller is configured to adjust a processing condition in the processing chamber for the substrate with the detected abnormality based on the score of that substrate.

10. The substrate processing system of Claim 1, wherein the outlier detection model is one of a local outlier factor (LOF) model, k-nearest neighbor method, and one-class support vector machine (SVM).

11. A substrate abnormality detection method comprising:
measuring an in-plane spectral distribution of a substrate by a measurer provided on a transfer path of the substrate between a storage container disposed on a load port to accommodate the substrate and a processing chamber configured to perform substrate processing on the substrate;
creating an outlier detection model based on the measured in-plane spectral distribution of the substrate;
calculating an in-plane score of the substrate from the measured in-plane spectral distribution of the substrate by using the created outlier detection model; and
detecting an abnormality in the substrate based on the calculated score.
